(19) Europäisches Patentamt
European Patent Office
Office européen des brevets

(11) **EP 3 848 960 B1**

(12) **EUROPEAN PATENT SPECIFICATION**

(45) Date of publication and mention
of the grant of the patent:
**25.02.2026 Bulletin 2026/09**

(21) Application number: **19858520.0**

(22) Date of filing: **04.09.2019**

(51) International Patent Classification (IPC):
**H01L 23/373** (2006.01)

(52) Cooperative Patent Classification (CPC):
**H10W 40/257; H10W 40/25; H10W 40/251;**
**H10W 40/259;** H10W 40/255

(86) International application number:
**PCT/JP2019/034847**

(87) International publication number:
**WO 2020/050334 (12.03.2020 Gazette 2020/11)**

(54) **HEAT CONDUCTIVE SHEET**

WÄRMELEITFOLIE

FEUILLE THERMOCONDUCTRICE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **07.09.2018 JP 2018168241**

(43) Date of publication of application:
**14.07.2021 Bulletin 2021/28**

(73) Proprietor: **Sekisui Polymatech Co., Ltd.**
**Saitama-city, Saitama 338-0837 (JP)**

(72) Inventors:
• **KUDOH, Hiroki**
**Saitama-city, Saitama 338-0837 (JP)**
• **LI, Chien-chiao**
**Saitama-city, Saitama 338-0837 (JP)**

(74) Representative: **Ter Meer Steinmeister & Partner**
**Patentanwälte mbB**
**Nymphenburger Straße 4**
**80335 München (DE)**

(56) References cited:
EP-A1- 3 007 531        EP-A1- 3 419 399
WO-A1-2017/172703    WO-A1-2017/179318
WO-A1-2017/179318    JP-A- 2000 336 279
JP-A- 2001 202 828      JP-A- 2004 253 531
JP-A- 2007 326 976      JP-A- 2012 238 916
JP-A- 2014 027 144      US-A1- 2006 234 056
US-A1- 2010 172 101    US-A1- 2011 030 938
US-A1- 2014 138 854

## Description

Technical Field

The present invention relates to a thermally conductive sheet, and relates to, for example, a thermally conductive sheet to be used by being disposed between a heating element and a heat-dissipating element.

Background Art

In electronic devices, such as a computer, an automobile part, and a cellular phone, a heat-dissipating element, such as a heat sink, is generally used for dissipating heat which is generated from a heating element such as a semiconductor element or a mechanical part. It is known that a thermally conductive sheet is disposed between a heating element and a heat-dissipating element for the purpose of enhancing the efficiency of heat transfer to the heat-dissipating element.

A thermally conductive sheet is generally used by being compressed when disposed inside an electronic device, and high flexibility is required in the thermally conductive sheet. Accordingly, a thermally conductive sheet is formed by blending a filler having thermal conductive properties in a polymer matrix having high flexibility, such as rubber or gel. It is widely known that a thermally conductive anisotropic material such as a carbon fiber, is oriented in the thickness direction in a thermally conductive sheet in order to enhance the thermal conductive properties in the thickness direction (see, for example, PTLs 1 - 5).

Citation List

Patent Literature

PTL1: JP 2018-056315 A
PTL2: JP 2018-014534 A
PTL3: US 2006/234056 A1
PTL4: US 2011/030938 A1
PTL5: US 2010/172101 A1

Summary of Invention

Technical Problem

As described above, the thermal conductive properties of a thermally conductive sheet can be improved by orienting a thermally conductive anisotropic material in the thickness direction. Such an anisotropic material is exposed on the surface of the thermally conductive sheet in some cases although it depends on the production method. A thermally conductive sheet containing a large amount of the exposed anisotropic material has good thermal conductive properties, but when it is used, falling off of the anisotropic material occurs and a defect occurs to an electronic device or the like in some cases.

The present invention has been completed in view of the above problem, and an object of the present invention is to provide a thermally conductive sheet capable of suppressing falling off of an anisotropic material in the thermally conductive sheet in which the anisotropic material is oriented in a thickness direction.

Solution to Problem

As a result of diligent studies, the present inventors have found that by providing a heat-softening layer on at least one surface of a heat-conducting layer in which an anisotropic material having thermal conductive properties is oriented in the thickness direction and is exposed on the surface of the heat-conducting layer, the problem can be solved, and thereby completed the present invention. The present invention is defined by the appended claims.

Advantageous Effects of Invention

According to the present invention, a thermally conductive sheet capable of suppressing falling off of an anisotropic material having thermal conductive properties can be provided.

Brief Description of Drawings

[Fig. 1] Fig. 1 is a schematic section view showing a thermally conductive sheet of the first embodiment.
[Fig. 2] Fig. 2 is a schematic section view showing a thermally conductive sheet of the second embodiment.
[Fig. 3] Fig. 3 is a schematic section view showing a thermally conductive sheet of the third embodiment.
[Fig. 4] Fig. 4 is a schematic section view showing a thermally conductive sheet of the fourth embodiment.
[Fig. 5] Fig. 5 is an outline diagram of a thermal resistance measuring machine.

Description of Embodiments

Hereinafter, a thermally conductive sheet according to embodiments of the present invention will be described in detail.

[First Embodiment]

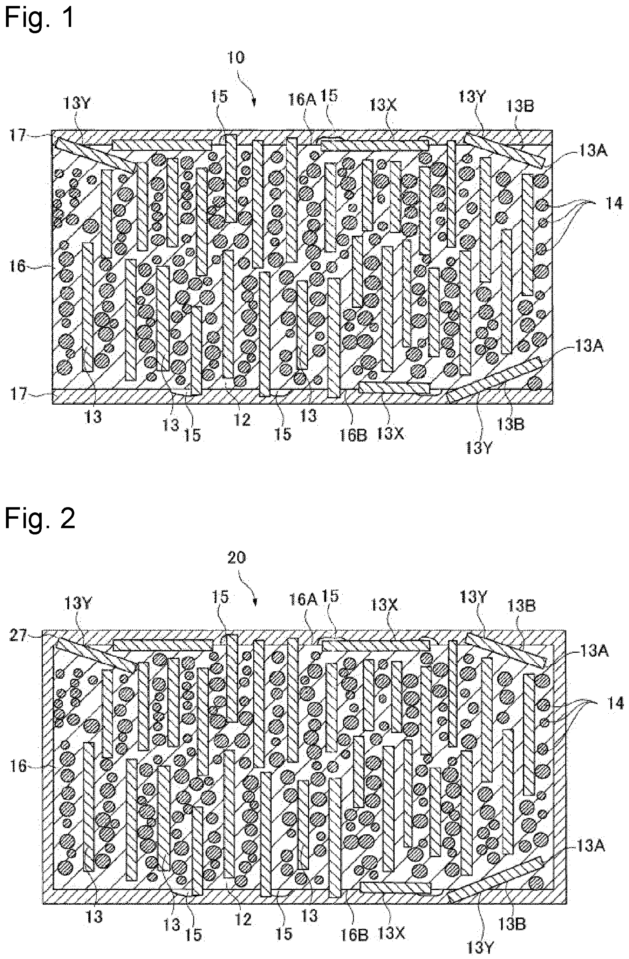

Fig. 1 shows a thermally conductive sheet according to the first embodiment. The thermally conductive sheet 10 according to the first embodiment comprises a heat-conducting layer 16 and a heat-softening layer 17 provided on surfaces 16A, 16B of the heat-conducting layer 16. The heat-conducting layer 16 comprises a polymer matrix 12 and an anisotropic material 13 as a filler, and the anisotropic material 13 is oriented in the thickness direction. At each surface 16A, 16B of the heat-conducting layer 16, the anisotropic material 13 which is exposed exists. Part of the exposed anisotropic material 13 is disposed in such a way as to lie down. The anisotropic material 13 has thermal conductive properties, and therefore the heat-conducting layer has excellent thermal conductive properties in the thickness direction.

In the present embodiment, the heat-conducting layer 16 further comprises a non-anisotropic material 14 as a filler different from the anisotropic material 13. The thermally conductive sheet 10, when further comprising the non-anisotropic material 14, makes the thermal conductive properties further better.

When the heat-conducting layer 16 is used singly by inserting it between objects of contact, such as a heat-dissipating element and a heating element, the thermal conductivity in the thickness direction of the heat-conducting layer 16 is enhanced, thereby making heat-dissipating properties excellent because the anisotropic material 13 exposed on the surface easily contacts with an object of contact, and the anisotropic material 13 is oriented in the thickness direction. However, the anisotropic material 13 exposed on the surface falls off through the contact or the like with the object of contact and adheres to the surface of the object of contact, thereby giving an adverse influence on the performance of an electronic device. Particularly, as shown in Fig. 1, when the amount of the anisotropic material 13X, 13Y, etc. which is disposed in such a way as to lie down is large, the thermal conductive properties of the heat-conducting layer 16 are good, but the anisotropic material is liable to fall off

In the first embodiment, the heat-softening layer 17 is provided on the surface of the heat-conducting layer 16 in order to prevent falling off of the anisotropic material 13 exposed on the surface. The heat-softening layer 17 covers the anisotropic material 13 which is exposed on the surface of the heat-conducting layer 16, and therefore falling off of the anisotropic material 13 from the surface of the heat-conducting layer 16 can be suppressed.

An aspect in which the heat-softening layer 17 is provided on at least one surface of the heat-conducting layer 16 can suppress falling off of the anisotropic material 13, but an aspect in which the heat-softening layer 17 is provided on each surface of the heat-conducting layer 16 like the first embodiment can suppress falling off of the anisotropic material 13 more effectively.

The heat-softening layer 17 is a layer having a characteristic of softening when heated, and is solid at normal temperature (25°C). The anisotropic material 13 which is exposed on the surface is covered with the heat-softening layer 17, but a void 15 occurs partially at an interface between the heat-softening layer 17 and the heat-conducting layer 16 in some cases. However, the heat-softening layer 17 is laminated exhibiting relatively good conformability to the shape of the surface of the heat-conducting layer 16, and therefore the volume of the void 15 is decreased outstandingly as compared to when, for example, a metal layer, such as an aluminum foil, is provided in place of the heat-softening layer. Therefore, the use of the heat-softening layer 17 can prevent falling off of the anisotropic material 13 more effectively and makes the thermal conductive properties better than when another material is used.

When the thermally conductive sheet 10 comprising a heat-softening layer 17 is disposed between a heating element and a heat-dissipating element, a gap occurs between the heating element and the heat-softening layer 17, and between the heat-dissipating element and the heat-softening layer 17 in some cases. Even in such a case, the heat-dissipating properties are enhanced through the fact that the heat-softening layer 17 softens or fluidizes due to heat generated by the heating element and the gap decreases or disappears. Further, when the heat-softening layer 17 softens or fluidizes, the void 15 at the above-described interface between the heat-softening layer 17 and the heat-conducting layer 16 becomes easy to fill with the heat-softening layer. Therefore, falling off of the anisotropic material 13 can be prevented effectively, and the thermal conductive properties are made good.

The heat-softening layer 17 preferably comprises a filler not shown. As the filler, a powder of a metal, a metal oxide, a metal nitride, a metal hydroxide, a carbon material, an oxide, nitride, or carbide other than a metal oxide, metal nitride, or metal carbide, or the like which has high thermal conductive properties is preferable, and when the heat-softening layer comprises such a filler, the thermal conductivity of the heat-softening layer 17 is thereby enhanced, making the thermal conductivity of the thermally conductive sheet 10 as a whole good.

<Heat-conducting Layer>

(Polymer Matrix)

The polymer matrix 12 which is used in the heat-conducting layer is a polymer compound, such as an elastomer or a rubber, and a product formed by curing a polymer composition (curable polymer composition) in a liquid form, the polymer composition comprising a mixed system such as the one comprising a main agent and a curing agent, may preferably be used. For example, the curable polymer composition may be a composition comprising an uncrosslinked rubber and a crosslinking agent, or a composition comprising: a monomer, a prepolymer, or the like; and a curing agent or the like. The curing reaction may be cold curing or heat curing.

Examples of the polymer matrix which is formed from the curable polymer composition include silicone rubber. In the case of silicone rubber, addition reaction-curable type silicone is preferably used as the polymer matrix (curable polymer composition). More specifically, a curable polymer composition comprising alkenyl group-containing organopolysiloxane and hydrogen organopolysiloxane may be used as the curable polymer composition.

Various synthetic rubbers other than the above-described rubber can be used as the rubber, and specific examples thereof include acrylic rubber, nitrile rubber, isoprene rubber, urethane rubber, ethylene propylene rubber, styrene/butadiene rubber, butadiene rubber, fluororubber, and butyl rubber. When any of these rubbers is used, the synthetic rubber may be crosslinked or left uncrosslinked (that is, uncured) in the thermally conductive sheet. Uncrosslinked rubber is used mainly in flow orientation.

When the synthetic rubber is crosslinked (that is, cured), the polymer matrix may be, as described above, a product obtained by curing a curable polymer composition comprising: an uncrosslinked rubber comprising any of these synthetic rubbers; and a crosslinking agent.

As the elastomer, a thermoplastic elastomer, such as a polyester-based thermoplastic elastomer or a polyurethane-based thermoplastic elastomer, or a heat-curable type elastomer which is formed by curing a polymer composition in a liquid form of a mixed system comprising a main agent and a curing agent can be used. Examples of the elastomer include a polyurethane-based elastomer which is formed by curing a polymer composition comprising: a polymer having a hydroxy group; and isocyanate.

Among those described above, silicone rubber, or particularly addition reaction-curable type silicone is preferably used from the viewpoint that, for example, the polymer matrix after curing is particularly flexible and filling properties of the above-described anisotropic material 13, non-anisotropic material 14, and the like are good.

The polymer composition for forming the polymer matrix may be a polymer composition comprising a single substance of a polymer compound, or may be a polymer composition comprising a polymer compound and a plasticizer. The plasticizer is suitably used when a synthetic rubber is used, and when the plasticizer is contained, the flexibility of the uncrosslinked polymer matrix can thereby be enhanced.

The plasticizer having compatibility with the polymer compound is used, and specifically, the plasticizer is preferably an ester-based plasticizer or silicone oil. Specific examples of the ester-based plasticizer include a phthalic acid ester, an adipic acid ester, a trimellitic acid ester, a phosphoric acid ester, a sebacic acid ester, an azelaic acid ester, a maleic acid ester, and a benzoic acid ester. Examples of the silicone oil include polydimethylsiloxane.

The content of the plasticizer to the polymer compound is preferably 5/95 to 60/40, and more preferably 10/90 to 55/45 in terms of a mass ratio of plasticizer/polymer compound. Setting the mass ratio of plasticizer/polymer compound to 60/40 or less makes it easy to retain the filler by the polymer compound. Setting the mass ratio to 5/95 or more makes the flexibility of the polymer matrix sufficient. The plasticizer is suitably used when the anisotropic material is oriented by the flow orientation which will be mentioned later.

The content of the polymer matrix, when expressed by a filling ratio on a volume basis (volume filling ratio), is preferably 20 to 50% by volume, and more preferably 25 to 45% by volume based on the total amount of the heat-conducting layer.

(Additive)

In the heat-conducting layer, various additives may further be blended in the polymer matrix 12 in a range where the function as the heat-conducting layer is not impaired. Examples of the additive include at least one or more selected from a dispersant, a coupling agent, a pressure-sensitive adhesive, a fire retardant, an antioxidant, a coloring agent, an anti-settling agent, and the like. When the curable polymer composition is subjected to crosslinking, curing, or the like, as described above, a crosslinking accelerator, a curing accelerator, or the like that accelerates crosslinking or curing may be blended as an additive.

(Anisotropic Material)

The anisotropic material 13 which is blended in the polymer matrix 12 is a thermally conductive filler that can be oriented. The anisotropic material is a material having a high aspect ratio and is specifically a material having an aspect ratio of exceeding 2, and the aspect ratio is preferably 5 or more. Setting the aspect ratio to larger than 2 makes it easy to orient the anisotropic material 13 in the thickness direction, so that the thermal conductive properties of the thermally conductive sheet are enhanced easily. The upper limit of the aspect ratio is not particularly limited, but is 100 in practical use. The aspect ratio means fiber length/diameter of fiber when the anisotropic material 13 is a fiber material, which will be mentioned later, and length of major axis /length of minor axis when the anisotropic material 13 is a flat material, which will be mentioned later.

The content of the anisotropic material 13 in the heat-conducting layer, when expressed by a filling ratio on a volume basis (volume filling ratio), is preferably 5 to 35% by volume, and more preferably 8 to 30% by volume based on the total amount of the heat-conducting layer.

Setting the content of the anisotropic material 13 to 5% by volume or more makes it easy to enhance the thermal conductive properties, and setting the content to 35% by volume or less easily makes the viscosity of the mixed composition, which will be mentioned later, proper, thereby making the orientation of the anisotropic material 13 good.

When the anisotropic material 13 is a fiber material, the average fiber length is preferably 5 to 600 μm, more preferably 10 to 200 μm, and still more preferably 70 to 180 μm. When the average fiber length is set to 5 μm or more, the anisotropic materials 13 come into contact properly inside the heat-conducting layer, so that heat transmission paths are secured. On the other hand, when the average fiber length is set to 600 μm or less, the bulk of the anisotropic material 13 is made low, so that the anisotropic material 13 can be made highly filled in the polymer matrix.

When the anisotropic material 13 is a flat material, the average major axis length is preferably 5 to 300 μm, more preferably 10 to 200 μm, and still more preferably 40 to 135 μm.

When the average major axis length is set to 5 μm or more, the anisotropic materials 13 come into contact properly inside the heat-conducting layer, so that heat transmission paths are secured. On the other hand, when the average major axis length is set to 300 μm or less, the bulk of the anisotropic material 13 is made low, so that the anisotropic material 13 can be made highly filled in the polymer matrix.

The above-described average fiber length, diameter of fiber, average major axis length, and average minor axis length can be calculated by observing the anisotropic material 13 with a microscope. More specifically, the fiber lengths of arbitrary 100 anisotropic materials are measured using, for example, an electron microscope or an optical microscope, and the average value (arithmetical mean value) can be adopted as the average fiber length. The diameter of fiber, the average major axis length, and the average minor axis length can be determined in the same manner.

The average fiber length or average major axis length of the anisotropic material 13 is shorter than the thickness of the heat-conducting layer. When the average fiber length or average major axis length is shorter than the thickness, the anisotropic material 13 is prevented from protruding from the surfaces 16A, 16B of the heat-conducting layer 16 more than necessary, making it easy to suppress falling off of the anisotropic material 13.

The anisotropic material 13 has a thermal conductivity of, though not limited to, generally 60 W/m·K or more, and preferably 400 W/m·K or more along a major axis direction. The anisotropic material 13 has a thermal conductivity of, for example, 2000 W/m·K or less although the upper limit is not particularly limited. The method of measuring the thermal conductivity is a laser flash method.

The anisotropic material 13 may be used singly, or two or more anisotropic materials 13 may be used together. For example, at least two anisotropic materials 13 each having a different average fiber length or average major axis length may be used as the anisotropic material 13. It is considered that when the anisotropic materials each having a different size are used, a smaller anisotropic material gets in between relatively larger anisotropic materials, and thereby the anisotropic materials can be filled up to high density in the polymer matrix and heat-conducting efficiency can be enhanced.

A known material having thermal conductive properties may be used as the anisotropic material 13, and as will be mentioned later, the anisotropic material 13 preferably has diamagnetism in such a way that the anisotropic material can be oriented by a magnetic field.

The anisotropic material 13 may satisfy the above-described aspect ratio, and preferably comprises at least one of the fiber material and the flat material.

The anisotropic material 13 may comprise a material other than the fiber material and the flat material, and is preferably a material consisting of only one of the fiber material and the flat material, or a material consisting of only both of the fiber material and the flat material.

Specific examples of the anisotropic material 13 include fiber materials, such as a metal fiber comprising iron, copper, silver, aluminum, stainless steel, or the like and a carbon fiber, and flat materials, such as scale-like graphite and boron nitride. Among the fiber materials, a carbon fiber is preferable because of small specific gravity and good dispersibility into the polymer matrix 12, and among carbon fibers, a graphitized carbon fiber is preferable. Among the flat materials, scale-like graphite is preferable.

The graphitized carbon fiber and the scale-like graphite have a high thermal conductivity, and therefore, when having graphite planes uniformly facing a predetermined direction, have diamagnetism.

The carbon fiber which is used as the anisotropic material 13 is preferably a graphitized carbon fiber as described above.

A graphitized carbon fiber has a high thermal conductivity in its fiber axis direction because crystal planes of graphite run in the fiber axis direction. Therefore, by allowing fiber axis directions of the graphitized carbon fiber to face uniformly in a predetermined direction, the thermal conductivity in a particular direction can be enhanced. The graphitized carbon fiber having a high degree of graphitization are preferable.

As the above-described graphitized carbon materials, such as the graphitized carbon fiber, products obtained by graphitizing the following raw materials can be used. Examples thereof include a condensed polycyclic hydrocarbon compound, such as naphthalene, and a condensed heterocyclic compound, such as PAN (polyacrylonitrile) or pitch, and graphitized mesophase pitch having a high degree of graphitization, polyimide, or polybenzazole in particular is preferably used. For example, by using mesophase pitch, the pitch is oriented in the fiber axis direction due to its anisotropy in the spinning step which will be mentioned later, so that a graphitized carbon fiber having excellent thermal conductive properties in the fiber axis direction can be obtained.

The aspect of using the mesophase pitch in the graphitized carbon fiber is not particularly limited as long as spinning can be conducted, and the mesophase pitch may be used singly, or may be used in combination with another raw material. However, the mesophase pitch is most preferably used singly, that is a graphitized carbon fiber having a content of mesophase pitch of 100% is most preferable from the viewpoint of enhancement in thermal conductive properties; spinnability; and stability in product quality.

The graphitized carbon fiber obtained such that treatments of spinning, infusibilization, and carbonization are conducted in sequence, and pulverization or cutting is conducted to a predetermined particle diameter, and thereafter graphitization is conducted, or the graphitized carbon fiber such that carbonization is conducted, pulverization or cutting is then conducted, and thereafter graphitization is conducted can be used. When pulverization or cutting is conducted before graphitization, a condensation polymerization and a cyclization reaction progress easily on a surface newly exposed due to pulverization during the graphitization treatment, and therefore a graphitized carbon fiber having thermal conductive properties further improved by enhancing the degree of graphitization can be obtained. When, on the other hand, pulverization is conducted after graphitizing a spun carbon fiber, the carbon fiber after graphitization is rigid and therefore is easily pulverized, so that a carbon fiber powder having a relatively narrow fiber length distribution can be obtained by brief pulverization.

The average fiber length of the graphitized carbon fiber is preferably 5 to 600 $\mu$m, more preferably 10 to 200 $\mu$m, and still more preferably 70 to 180 $\mu$m as described above. The aspect ratio of the graphitized carbon fiber exceeds 2, and more preferably 5 or more, as described above. The thermal conductivity of the graphitized carbon fiber is not particularly limited, but the thermal conductivity in the fiber axis direction is preferably 400 W/m·K or more, and more preferably 800 W/m·K or more.

The flat material which is used as the anisotropic material 13 is preferably scale-like graphite.

The scale-like graphite has a high thermal conductivity in its in-plane direction because crystal planes of graphite run in the in-plane direction of the scale plane. Therefore, by allowing scale planes of the scale-like graphite to face uniformly in a predetermined direction, the thermal conductivity in a particular direction can be enhanced. The scale-like graphite having a high degree of graphitization is preferable.

Natural graphite can be used as the scale-like graphite in addition to the same raw materials for the graphitized carbon fiber. Among others, a product obtained by graphitizing a condensed polycyclic hydrocarbon compound, such as naphthalene, or a polyimide film and pulverizing a resultant product is preferable.

The average major axis length of the scale-like graphite is preferably 5 to 300 $\mu$m, more preferably 10 to 200 $\mu$m, and still more preferably 40 to 135 $\mu$m, as described above. The aspect ratio of the scale-like graphite exceeds 2, and is preferably 5 or more, as described above. The thermal conductivity of the scale-like graphite is not particularly limited, and the thermal conductivity in the scale plane direction is preferably 400 W/m·K or more, and more preferably 800 W/m·K or more.

The length of the major axis of the scale-like graphite indicates the length in a direction where the in-plane length of the scale plane is longest, and the length of the minor axis of the scale-like graphite indicates the thickness of the graphite.

The anisotropic material 13 is oriented in the thickness direction as described above, but the major axis direction does not necessarily need to be strictly parallel to the thickness direction, and if the major axis direction inclines somewhat in the thickness direction, the anisotropic material is assumed to be oriented in the thickness direction. Specifically, an anisotropic material whose major axis direction inclines by about less than 20° is assumed to be the anisotropic material 13 which is oriented in the thickness direction, and when such an anisotropic material 13 is the majority (for example, exceeding 60%, and preferably exceeding 80% based on the total number of carbon fibers) in the heat-conducting layer, the anisotropic material is oriented in the thickness direction.

The orientation direction (angle) of the anisotropic material 13 and the proportion of the anisotropic material 13 which is oriented can be estimated by observing an arbitrary section perpendicular to the surface of the thermally conductive sheet 10 with an electron microscope or an optical microscope and measuring orientation angles of arbitrary 100 anisotropic materials.

(Filler Other Than Anisotropic Material)

The heat-conducting layer may further comprise a non-anisotropic material 14 as a filler other than the above-described anisotropic material.

The non-anisotropic material 14 is a thermally conductive filler contained in the thermally conductive sheet separately from the anisotropic material 13 and is a material which, together with the anisotropic material 13, imparts thermal conductive properties to the thermally conductive sheet 10. By filling the non-anisotropic material 14, an increase in the viscosity is suppressed, making the dispersibility good in the stage prior to curing into the heat-conducting layer. In addition, in the anisotropic materials 13, when, for example, the fiber length is large, it is difficult to increase the contact area between the anisotropic materials, but when the non-anisotropic material 14 fills the space between the anisotropic materials, heat transfer paths can thereby be formed, so that the thermally conductive sheet 10 having a high thermal conductivity is obtained.

The non-anisotropic material 14 is a filler whose shape is substantially free of anisotropy, and is a filler such that even in an environment where the anisotropic material 13 is oriented in a predetermined direction, such as an environment, which will be mentioned later, where lines of magnetic force are generated or shear force is applied, the non-anisotropic material 14 is not oriented in the predetermined direction.

The non-anisotropic material 14 has an aspect ratio of 2 or less, and preferably 1.5 or less. In the present embodiment, when the non-anisotropic material 14 having such a low aspect ratio is contained, the filler having thermal conductive properties is thereby properly interposed in the space between the anisotropic materials 13, so that the thermally conductive sheet having a high thermal conductivity is obtained. In addition, by setting the aspect ratio to 2 or less, an increase in the viscosity of the mixed composition which will be mentioned later is prevented, enabling the thermally conductive sheet to be highly filled.

Specific examples of the non-anisotropic material 14 include a metal, a metal oxide, a metal nitride, a metal hydroxide, a carbon material, and an oxide, a nitride, and a carbide other than the metal oxide, the metal nitride, and a metal carbide. Examples of the shape of the non-anisotropic material 14 include a spherical shape and an indefinite-form powder.

In the non-anisotropic material 14, examples of the metal include aluminum, copper, and nickel, examples of the metal oxide include aluminum oxide represented by alumina, magnesium oxide, and zinc oxide, and examples of the metal nitride include aluminum nitride. Examples of the metal hydroxide include aluminum hydroxide. Examples of the carbon material include spheroidal graphite. Examples of the oxide, the nitride, and the carbide other than the metal oxide, the metal nitride, and the metal carbide include quartz, boron nitride, and silicon carbide.

Among these described above, the non-anisotropic material 14 is preferably selected from the group consisting of alumina, aluminum, zinc oxide, boron nitride, and aluminum nitride, and alumina in particular is preferable from the viewpoint of filling properties and thermal conductivity.

As the non-anisotropic material 14, those described above may be used singly, or two or more of those described above may be used together.

The average particle diameter of the non-anisotropic material 14 is preferably 0.1 to 50 $\mu$m, and more preferably 0.5 to 35 $\mu$m. The average particle diameter is particularly preferably 1 to 15 $\mu$m. By setting the average particle diameter to 50 $\mu$m or less, a defect such as disturbing the orientation of the anisotropic material 13, or the like is made unlikely to occur. By setting the average particle diameter to 0.1 $\mu$m or more, the specific surface area of the non-anisotropic filler 14 is not made larger than needed, making the viscosity of the mixed composition unlikely to increase even when a large amount is blended and making it easy to highly fill the non-anisotropic filler 14.

With respect to the non-anisotropic material 14, for example, at least two non-anisotropic fillers 14 each having a different average particle diameter may be used as the non-anisotropic filler 14.

The average particle diameter of the non-anisotropic material 14 can be measured by observation with an electron microscope or the like. More specifically, the particle diameters of arbitrary 50 fillers are measured using, for example, an electron microscope or an optical microscope, and the average value (arithmetical mean value) can be adopted as the average particle diameter.

The content of the non-anisotropic material 14 is preferably in a range of 200 to 800 parts by mass, and more preferably in a range of 300 to 700 parts by mass based on 100 parts by mass of the polymer matrix.

The content of the non-anisotropic material 14, when expressed by a filling ratio on a volume basis (volume filling ratio), is preferably 30 to 60% by volume, and more preferably 40 to 55% by volume based on the total amount of the heat-conducting layer.

By setting the content of the non-anisotropic material 14 to 30% by volume or more, the amount of the non-anisotropic material 14 interposed in the space between the anisotropic material 13 is made sufficient, making the thermal conductive properties good. On the other hand, by setting the content to 60% by volume or less, an effect of enhancing the thermal conductive properties corresponding to the content can be obtained, and the heat conduction due to the anisotropic material 13 is not inhibited by the non-anisotropic filler 14. Further, by setting the content within the range of 40 to 55% by volume, the thermal conductive properties of the thermally conductive sheet are made excellent and the viscosity of the mixed composition is made suitable.

The ratio of the volume filling ratio of the anisotropic material 13 to the volume filling ratio of the non-anisotropic material 14 is preferably 2 to 5, and more preferably 2 to 3. By setting the range of the proportion of the volume filling ratios to the above-described range, the non-anisotropic filler 14 is filled moderately between the anisotropic materials 13, so that efficient heat transfer paths can be formed, and therefore the thermal conductive properties of the thermally conductive sheet can be improved.

The thickness of the heat-conducting layer may appropriately be adjusted according to the shape and intended use of an electronic device on which the thermally conductive sheet is loaded, therefore is not particularly limited, and may be set in a range of, for example, 0.1 to 5 mm.

The thickness of the heat-conducting layer can be determined by observing a section of the thermally conductive sheet with a scanning electron microscope or an optical microscope.

<Heat-softening Layer>

The heat-softening layer is a layer which is solid at normal temperature (25°C) and has a characteristic of softening when heated to, for example, about 35 to about 120°C.

The composition of the heat-softening layer is not particularly limited, and preferably comprises a non-silicone-based material. "Non-silicone-based" herein means that the heat-softening layer is substantially free of a compound having a siloxane bond, and "substantially free of a compound having a siloxane bond" means that a compound having a siloxane bond is not blended intentionally.

When the heat-softening layer comprises a non-silicone-based material, contact failure due to production of low-molecular-weight siloxane can thereby be prevented.

The heat-softening layer preferably comprises a wax-like substance having a melting point of 35 to 120°C. This makes it easy to suppress falling off of the anisotropic material exposed on the surface of the heat-conducting layer. A melting point of 35°C or higher can prevent the heat-softening layer from becoming excessively flexible at normal temperature to make the handling properties bad. Melting point of 120°C or lower makes the heat-softening layer soft or fluid at a proper temperature, so that versatility is improved.

The melting point of the wax-like substance is preferably 35 to 80°C, and more preferably 40 to 60°C.

The wax-like substance preferably has a narrow temperature range from the start of melting to the end of melting. The reason is that when this temperature range is narrower, the wax-like substance more quickly changes its phase to closely adhere to an object of contact. Examples of the material in which this temperature range is narrow include a substance having a narrow molecular weight distribution and a substance having crystallinity. In the wax-like substance, the difference between the temperature at the end of melting and the temperature at the start of melting (temperature at the end of melting - temperature at the start of melting) is preferably 15°C or less, more preferably 10°C or less, and still more preferably 8°C or less.

The melting point in the present specification refers to a temperature at the endothermic peak of a DSC curve measured by differential scanning calorimetry (DSC). The temperature range from the start of melting to the end of melting refers to a range between the temperature at the intersection point of the base line of the DSC curve and the tangential line at the infection point on the DSC curve from the base line toward the endothermic peak and the temperature at the intersection point of the base line of the DSC curve and the tangential line at the infection point on the DSC curve from the endothermic peak toward the base line.

The wax-like substance is preferably non-silicone-based and is preferably at least one wax-like substance selected from the group consisting of a paraffin-based wax, an ester-based wax, and a polyolefin-based wax. There is a tendency that such a wax-like substance has a relatively narrow temperature range from the start of melting to the end of melting and has high fluidity when heated, and therefore by using the heat-softening layer comprising the wax-like substance, falling off of the anisotropic material 13 can effectively be suppressed. Among the wax-like substances, a paraffin-based wax is preferable.

When the heat-softening layer comprises a wax-like substance, the whole heat-softening layer may consist of the wax-like substance, and the wax-like substance and a filler, which will be mentioned later, are preferably used together. Accordingly, the volume filling ratio of the wax-like substance in the heat-softening layer is preferably 15 to 80% by volume, more preferably 20 to 60% by volume, and still more preferably 30 to 50% by volume based on the total amount of the heat-softening layer.

The heat-softening layer preferably comprises a filler. When the heat-softening layer comprises a filler, thereby the thermal conductivity of the heat-softening layer is improved and the thermal conductivity of the whole thermally conductive sheet is improved.

The filler is not particularly limited, and is preferably a filler which is less likely to fall off from the heat-softening layer, and specifically, the aforementioned non-anisotropic material 14 can be used. As the filler which is blended in the heat-softening layer, a material which is the same or which is different from the aforementioned non-anisotropic material 14 may be used, and a material which is the same as the aforementioned non-anisotropic material 14 is preferably used.

The filler which is blended in the heat-softening layer is preferably selected from alumina, aluminum, zinc oxide, boron nitride, and aluminum nitride, and particularly, alumina is preferable from the viewpoint of the filling property and the thermal conductivity.

The average particle diameter of the filler which is blended in the heat-softening layer is preferably 0.1 to 50 $\mu$m, more preferably 0.5 to 35 $\mu$m, and particularly preferably 1 to 15 $\mu$m.

The volume filling ratio of the filler in the heat-softening layer is preferably 20 to 85% by volume, and more preferably 40 to 80% by volume based on the total amount of the heat-softening layer. When the volume filling ratio is in such a range, the thermal conductive properties can be improved without inhibiting the easiness of softening of the heat-softening layer at the time of heating. In addition, the rate of increase in a thermal resistance value of the thermally conductive sheet, which will be mentioned later, is easily adjusted in a desired range.

The thickness of the heat-softening layer is better when it is thicker from the viewpoint of preventing falling off of the anisotropic material 13, and is preferably 5 to 45 $\mu$m, more preferably 10 to 40 $\mu$m, and still more preferably 10 to 30 $\mu$m from the viewpoint of making the thermal conductive properties of the thermally conductive sheet better and suppressing falling off of the anisotropic material 13. When the thickness of the heat-softening layer is 5 $\mu$m or more, falling off of the anisotropic material is easily prevented, and when the thickness is 45 $\mu$m or less, the thermal conductivity of the thermally conductive sheet is easily kept high and the thermal resistance value and rate of increase in a thermal resistance value of the thermally conductive sheet, which will be mentioned later, are easily adjusted in a desired range.

When the heat-softening layer is provided on each surface of the heat-conducting layer, the thickness of the heat-softening layer to be provided at least one surface is preferably set to the above-described range, and the thickness of each heat-softening layer to be provided on each surface is more preferably set to the above-described range.

The thickness of the heat-softening layer is preferably thinner than the thickness of the heat-conducting layer, preferably 0.1 times the thickness of the heat-conducting layer or less, and more preferably 0.02 times the thickness of the heat-conducting layer or less, and is preferably 0.005 times the thickness of the heat-conducting layer or more from the viewpoint of making the thermal conductive properties of the thermally conductive sheet good.

The thickness of the heat-softening layer means an average thickness obtained by observing a section of the thermally conductive sheet 10 with a scanning electron microscope, measuring the thicknesses of ten points at even intervals in the part of the heat-softening layer, and taking the average of the values. The thickness of the heat-softening layer may be a thickness immediately after production or may be a thickness measured when what is installed between a heating element and a heat-dissipating element is removed.

The heat-softening layer may further comprise an additional component other than the above-described wax-like substance and filler in a range not impairing the functions thereof, and examples of the additional component include a surfactant, a reinforcing material, a coloring agent, a heat resistance improver, a coupling agent, a fire retardant, and a deterioration preventive agent.

<Thermally Conductive Sheet>

The thermal resistance value of the thermally conductive sheet of the present invention at 10% compression is preferably 0.15°C in$^2$/W (0.96774°C cm$^2$/W) or less, and more preferably 0.10°C in$^2$/W (0.64516°C cm$^2$/W) or less. By setting the thermal resistance value as described above, the thermal conductive properties of the thermally conductive sheet can be enhanced.

The thermal resistance value of the thermally conductive sheet at 10% compression may be better when it is lower, and is practically 0.01°C in$^2$/W (0.064516°C cm$^2$/W) or more.

The thermal resistance value can be measured by the method described in Examples.

With respect to the thermal resistance value of the thermally conductive sheet of the present invention, a rate of increase in the thermal resistance value as compared to the thermal resistance value of a thermally conductive sheet not having the heat-softening layer is preferably 10% or less. This rate of increase in the thermal resistance value indicates a rate of increase in the thermal resistance value due to the fact that the heat-softening layer is provided, and when this is 10% or less, thereby the thermally conductive sheet of the present invention prevents falling off of the anisotropic material and can keep the thermal conductive properties of the thermally conductive sheet high.

The rate of increase in the thermal resistance value is more preferably 5% or less, and preferably 3% or less.

The rate of increase in the thermal resistance value may have a negative value (such as, for example, -5% or less). When the rate of increase in the thermal resistance value takes a negative value, it means that the thermal resistance value is decreased by providing the heat-softening layer. For example, when the surface of the heat-conducting layer is not polished, or when the extent of polishing is weak even though the surface of the heat-conducting layer is polished, the unevenness of the surface is large, but by providing the heat-softening layer having a proper thickness on the surface of the heat-conducting layer, the unevenness is reduced to make the thermal resistance value low.

The rate of increase in the thermal resistance value is better when it is lower, and is practically -50% or more.

The rate of increase of the thermal resistance value can be determined by the expression $100 \times (A\text{-}B)/B$ when the thermal resistance value of the thermally conductive sheet is assumed to be A, and the thermal resistance value of the thermally conductive sheet not having the heat-softening layer is assumed to be B.

Specifically, the rate of increase in the thermal resistance value can be determined by, for example, measuring the thermal resistance value A of the thermally conductive sheet comprising the heat-softening layer and measuring the thermal resistance value B of a thermally conductive sheet from which the heat-softening layer has been removed. As the method of removing the heat-softening layer herein, a method of removing the heat-softening layer by dissolving the heat-softening layer with a solvent in which the heat-softening layer dissolves but the thermal conducting properties do not dissolve, a method of heating the heat-softening layer to a predetermined temperature into a molten state and wiping off the heat-softening layer, and the like can be adopted.

The load on the thermally conductive sheet at 40% compression is preferably 50 N or less, and preferably 30 N or less. By adjusting the load at the time of compression in this way, a burden on an object of contact at the time of using the thermally conductive sheet is reduced, so that damage to the object of contact is suppressed.

The load on the thermally conductive sheet at 40% compression can be determined by measuring the compressive load when the thermally conductive sheet is compressed until the thickness of the thermally conductive sheet becomes 60% of the thickness before compression. The load on the thermally conductive sheet at 40% compression is mainly influenced by the composition, thickness, and the like of the heat-conducting layer and therefore can be adjusted into a desired range by adjusting these.

<Method for Producing Thermally Conductive Sheet>

The thermally conductive sheet of the present embodiment can be produced by, for example, a method comprising the following steps (A), (B) and (C) although the method is not particularly limited thereto.

Step (A): a step of obtaining an oriented molding such that an anisotropic material is oriented along a direction to be a thickness direction in the heat-conducting layer
Step (B): a step of cutting the oriented molding into a sheet to obtain a heat conductive layer
Step (C): a step of forming a heat-softening layer on a surface of the heat-conducting layer

Hereinafter, each step will be described in more detail.

[Step (A)]

In the step (A), an oriented molding is molded from a mixed composition comprising: an anisotropic material 13; a non-anisotropic material 14; and a polymer composition to be a raw material for a polymer matrix. The mixed composition is preferably cured into an oriented molding. More specifically, the oriented molding can be obtained by a production method by magnetic field orientation or a production method by flow orientation, but among these, the production method by magnetic field orientation is preferable.

(Production Method by Magnetic Field Orientation)

In the production method by magnetic field orientation, the mixed composition comprising: a polymer composition in a liquid form to be a polymer matrix after curing; an anisotropic material 13; and a non-anisotropic material 14 is injected inside a die or the like and is then placed in a magnetic field to orient the anisotropic material 13 along the magnetic field, and the polymer composition is thereafter cured, thereby obtaining an oriented molding. The oriented molding is preferably molded into a block-like form.

A release film may be disposed at a portion which is to be in contact with the mixed composition inside the die. As the release film, for example, a resin film having good releasability, or a resin film such that one surface is release-treated with a release agent or the like is used. Using a release film makes it easy to release the oriented molding from the die.

The viscosity of the mixed composition which is used in the production method by magnetic field orientation is preferably 10 to 300 Pa·s in order to subject the anisotropic material to magnetic field orientation. By setting the viscosity to 10 Pa·s or more, the anisotropic material 13 and the non-anisotropic material 14 are made unlikely to settle. By setting the viscosity to 300 Pa·s or less, the fluidity is made good, the anisotropic material 13 is oriented properly in the magnetic field, and a defect such as taking too much time for orientation does not occur. The viscosity refers to viscosity measured using a rotational viscometer (Brookfield viscometer DV-E, Spindle SC4-14) at a rotational speed of 10 rpm at 25°C.

However, when an anisotropic material 13 and a non-anisotropic material 14 which are unlikely to settle are used, or an additive, such as an anti-settling agent, is combined, the viscosity of the mixed composition may be set to less than 10 Pa·s.

Examples of a source for generating lines of magnetic force, the source for applying the lines of magnetic force, in the production method by magnetic field orientation include a superconducting magnet, a permanent magnet, and an electromagnet, and a superconducting magnet is preferable from the viewpoint that a magnetic field with a high magnetic flux density can be generated. The magnetic flux density of the magnetic field which is generated from these sources for generating lines of magnetic force is preferably 1 to 30 tesla. Setting the magnetic flux density to 1 tesla or more enables the above-described anisotropic material 13 comprising a carbon material and the like to be oriented easily. Setting the magnetic flux density to 30 tesla or less enables practical production.

Curing of the polymer composition may be conducted by heating, and may be conducted at a temperature of, for example, about 50 to about 150°C. The heating time is, for example, about 10 minutes to about 3 hours.

(Production Method by Flow Orientation)

In the production method by flow orientation, shear force may be applied to the mixed composition to produce a preliminary sheet such that the anisotropic material is oriented in the plane direction, a plurality of the preliminary sheets may be laminated to produce a laminated block, and the laminated block may be used as the oriented molding.

More specifically, in the production method by flow orientation, an anisotropic material 13, a non-anisotropic material 14, and if necessary, various additives are first mixed with the polymer composition to stir a resultant mixture, thereby preparing a mixed composition in which mixed solid substances are uniformly dispersed. The polymer compound which is used for the polymer composition may be a polymer compound comprising a polymer compound in a liquid form at normal temperature (23°C) or may be a polymer compound comprising a polymer compound in a solid form at normal temperature. Further, the polymer composition may comprise a plasticizer.

The mixed composition has a relatively high viscosity such that shear force is applied when the mixed composition is stretched into a sheet-like form, and specifically, the viscosity of the mixed composition is preferably 3 to 50 Pa·s. A solvent is preferably blended in the mixed composition in order to obtain the viscosity.

Next, the mixed composition is molded into a sheet-like form (preliminary sheet) by stretching flatly while shear force is given to the mixed composition. By applying the shear force, the anisotropic material 13 can be oriented in the shear direction. With respect to means for molding the sheet, a base film may be coated with the mixed composition, for example, with an applicator for application, such as a bar coater or a doctor blade, or by extrusion molding or ejection from a nozzle, and thereafter, drying may be conducted or the mixed composition may be semi-cured as necessary. The thickness of the preliminary sheet is preferably set to about 50 to about 250 μm. In the preliminary sheet, the anisotropic material is oriented in a direction along the plane direction of the sheet. Specifically, when the anisotropic material is a fiber material, the anisotropic material is oriented in such a way that the fiber axis direction faces the application direction, and when the anisotropic material is a flat material, the anisotropic material is oriented in such a way that the major axis faces the application direction, and the minor axis faces the normal direction to the sheet surface.

Subsequently, a plurality of the preliminary sheets may be stacked and laminated in such a way that the orientation directions are the same, and thereafter the preliminary sheets may be allowed to adhere to one another with a heat press or the like while the mixed composition is cured as necessary by heating, irradiation with an ultraviolet ray, or the like to form a laminated block, and the laminated block may be used as the oriented molding.

[Step (B)]

In the step (B), the oriented molding obtained in the step (A) is cut by slicing or the like perpendicularly to a direction of the orientation of the anisotropic material 13, thereby obtaining a heat-conducting layer. The slicing may be conducted with, for example, a shearing blade. In the heat-conducting layer, an edge of the anisotropic material 13 is exposed from the polymer matrix on each surface which is a section by cutting, such as slicing. Further, at least part of the exposed anisotropic material 13 protrudes from each surface. Almost all the exposed anisotropic materials are oriented in the thickness direction without falling off.

After the step (B), the surface of the heat-conducting layer, on which the anisotropic material has been exposed, may be polished. By polishing the surface of the heat-conducting layer, part of the exposed anisotropic material 13 is made to fall off. Thereby, the thermal conductivity in the thickness direction of the heat-conducting layer is improved. The anisotropic material 13 which has been made to fall off falls easily, but since the heat-softening layer is used, falling off of the anisotropic material 13 which has been made to fall off can be suppressed. The amount of the anisotropic material 13 which is made to fall off can be adjusted by, for example, the strength of polishing, the number of times of polishing, or the like.

[Step (C)] Step of Forming Heat-softening Layer on Surface of Heat-conducting Layer

The step (C) is a step of forming the heat-softening layer on the surface of the heat-conducting layer. The means for forming the heat-softening layer is not particularly limited, and the heat-softening layer may be formed on the surface of the heat-conducting layer by, for example, mixing respective components which are raw materials for the heat-softening layer, such as a wax-like substance and a filler, thereafter molding a resultant mixture into a sheet-like form to form a heat-softening sheet, and compression-bonding the heat-softening sheet to the surface of the heat-conducting layer, and a method as described below is preferable.

A solvent is added to respective components, such as a wax-like substance and a filler, which are raw materials for the heat-softening layer, to prepare a past-like composition. By applying the paste-like composition on the surface of the heat-conducting layer and volatilizing the solvent, the heat-softening layer can be formed on the surface of the heat-conducting layer.

The solvent is not particularly limited and may appropriately be selected taking the applicability, the volatility, and the like into consideration, and when a paraffin-based wax or a polyolefin-based wax is used as the wax-like substance, a hydrocarbon-based solvent, an aromatic solvent, a ketone-based solvent, an ester-based wax, or the like is preferably used.

In the above description, an aspect in which the anisotropic material 13 is exposed on the surfaces 16A, 16B of the heat-conducting layer is shown. However, in the present invention, the anisotropic material 13 may be exposed on only one of the surfaces 16A, 16B, and the other one may be a surface where the anisotropic material 13 has been buried inside the polymer matrix 12. The outermost surface of the oriented molding produced by the above-described production method by magnetic field orientation is a skin layer in which the proportion of the anisotropic material filled is lower than that of the other portions, typically in which the anisotropic material 13 is not contained. Accordingly, by using, for example, the outermost surface of the oriented molding as the other one of the surfaces 16A, 16B of the heat-conducting layer, the other one of the surfaces 16A, 16B can be made into a surface where the anisotropic material 13 has been buried inside the polymer matrix 12. When the surfaces are made such that the anisotropic material 13 has been exposed on only one of the surfaces 16A, 16B, and the anisotropic material 13 has been buried inside the polymer matrix 12 at the other one, the heat-softening layer is preferably formed only on the surface on which the anisotropic material 13 has been exposed.

[Second Embodiment]

Fig. 2 shows the thermally conductive sheet of the second embodiment. In the thermally conductive sheet 20 according to the second embodiment, the heat-softening layer 27 is further provided on the end surfaces of the heat-conducting layer 16 in addition to the aspect of the thermally conductive sheet 10 of the first embodiment. Such an aspect makes it easy to suppress falling off of the anisotropic material 13 from the end surfaces of the heat-conducting layer. Particularly, when the thermally conductive sheet 20 is compressed and used, the anisotropic material is liable to fall off from the end surfaces of the heat-conducting layer, and therefore the heat-softening layer may be preferably provided at the end surfaces.

When the heat-softening layer 27 is provided on the end surface of the heat-conducting layer, the heat-softening layer 27 may be provided on at least one end surface, and the aspect in which the heat-softening layer 27 is provided on the whole peripheral end surfaces as shown in Fig. 2 is preferable from the viewpoint of effectively suppressing falling off of the anisotropic material from the end surfaces.

When the heat-softening layer 27 is provided on the end surface of the heat-conducting layer 16, the thickness can be about the same as the thickness of the heat-softening layer provided on the surface of the heat-conducting layer 16, but can be thicker. When the heat-softening layer is provided on the whole peripheral end surfaces of the heat-conducting layer, the thicknesses of the heat-softening layer of the parts of the outer periphery may be about the same or different.

To obtain the thermally conductive sheet 20 in which the heat-softening layer 27 is also provided on the end surface of the heat-conducting layer 16, the heat-softening layer may also be formed on the end surface of the heat-conducting layer. As the method for forming the heat-softening layer on the end surface of the heat-conducting layer, the following methods can be adopted.

When the thickness of the heat-conducting layer is thin, the heat-softening layer is formed on the surface of the heat-conducting layer, and at the same time, the end surface of the heat-conducting layer can also be covered with the protruding heat-softening layer. When the thickness of the heat-conducting layer is thick, the heat-softening layer can be formed on the end surface of the heat-conducting layer by the same method as the method for forming the heat-softening layer on the surface of the heat-conducting layer.

[Third Embodiment]

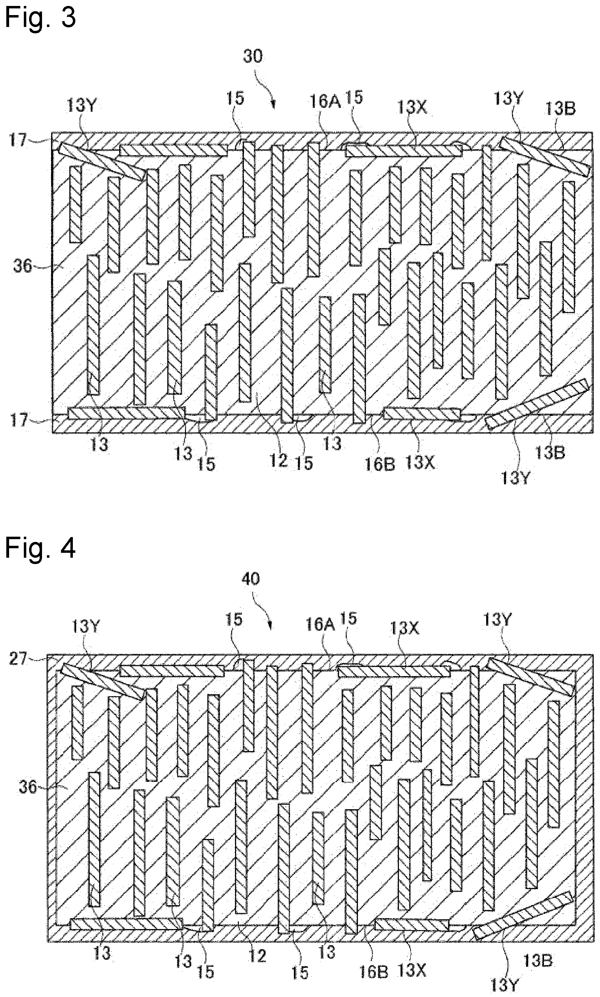

Next, the thermally conductive sheet of the third embodiment of the present invention will be described with reference to Fig. 3.

In the first embodiment, the non-anisotropic material 14 is contained in addition to the anisotropic material 13 in the thermally conductive sheet 30, but a non-anisotropic material 14 is not contained in a thermally conductive sheet 30 of the present embodiment, as shown in Fig. 3. That is, in the thermally conductive sheet of the first embodiment, only a carbon fiber, for example, may be used as a filler.

The other constitution of the thermally conductive sheet 30 of the third embodiment is the same as that of the above-described thermally conductive sheet 10 of the first embodiment, except that the non-anisotropic material 14 is not contained, and therefore the description is omitted.

Also, in the present embodiment, the heat-softening layer is provided on the surfaces of the heat-conducting layer, and falling off of the anisotropic material exposed on the surfaces of the heat-conducting layer can thereby be prevented in the same manner as in the first embodiment.

[Fourth Embodiment]

Next, the thermally conductive sheet of the fourth embodiment of the present invention will be described with reference to Fig. 4.

In the second embodiment, the non-anisotropic material 14 in addition to the anisotropic material 13 is contained in the thermally conductive sheet 20, but the non-anisotropic material 14 is not contained in the thermally conductive sheet 40 of the present embodiment, as shown in Fig. 4. That is, in the thermally conductive sheet of the fourth embodiment, only a carbon fiber for example may be used as a filler.

The other constitution of the thermally conductive sheet 40 of the fourth embodiment is the same as that of the above-described thermally conductive sheet 20 of the second embodiment, except that the non-anisotropic material 14 is not contained, and therefore the description is omitted.

Also, in the present embodiment, the heat-softening layer is provided on the surfaces and end surfaces of the heat-conducting layer, and falling off of the anisotropic material exposed on the surfaces of the heat-conducting layer can thereby be prevented in the same manner as in the second embodiment.

[Use of Thermally Conductive Sheet]

The thermally conductive sheet of the present invention can preferably be used by being disposed between a heating element and a heat-dissipating element in an electronic device. Examples of the heating element include an electronic element, and examples of the heat-dissipating element include a heat sink and a heat pipe. When the thermally conductive sheet of the present invention is used by being disposed between a heating element and a heat-dissipating element, the heat-softening layer softens or fluidizes due to heat, thereby the adhesiveness between the thermally conductive sheet and the heating element and between the thermally conductive sheet and the heat-dissipating element is enhanced and falling off of the anisotropic material is suppressed, so that the occurrence of a defect in an electronic device can be prevented.

Examples

Hereinafter, the present invention will be described with reference to Examples in more detail, but the present invention is not limited at all by these Examples.

In the present Examples, the physical properties of the thermally conductive sheets were evaluated by the following methods.

[Load at 40% Compression]

The compressive load at the time when each sample was compressed until the thickness became 60% of the initial thickness was measured with a load measuring instrument.

[Thermal Resistance Value at 10% Compression]

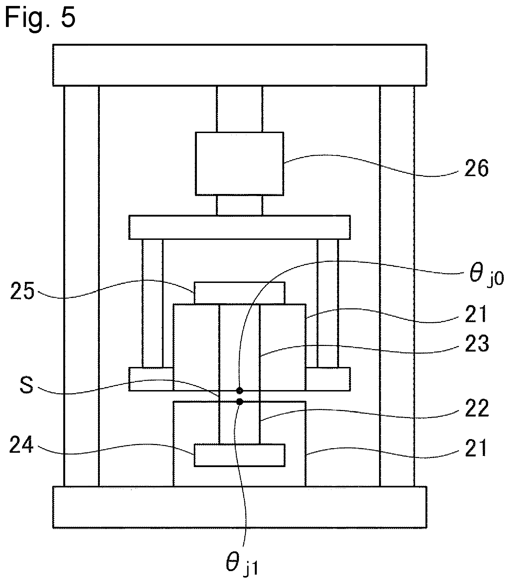

The thermal resistance value was measured using a thermal resistance measuring machine as shown in Fig. 5 by the method described below. Specifically, a test piece S having a size of 30 mm × 30 mm for the present test was prepared for each sample. Each test piece S was pasted on a copper block 22 such that a measurement face has a size of 25.4 mm × 25.4 mm and side faces are covered with a thermal insulator 21, and was held between the copper block and an upper copper block 23, and load was applied with a load cell 26 to set the thickness in such a way as to become 90% of the original thickness. The lower copper block 22 is in contact with a heater 24. The upper copper block 23 is covered with the thermal insulator 21 and is connected to a heat sink 25 with a fan. Subsequently, the heater 24 was heated by a calorific value of 25 W, and 10 minutes later when the temperature would reach an almost stationary state, the temperature of the upper copper block 23 ($\theta_{j0}$), the temperature of the lower copper block 22 ($\theta_{j1}$), and the calorific value of the heater (Q) were measured to determine the thermal resistance value of each sample from the following expression (1).

$$\text{Thermal resistance} = (\theta_{j1}\text{-}\theta_{j0})/Q \qquad \cdots \text{ Expression (1)}$$

wherein $\theta_{j1}$ represents the temperature of the lower copper block 22, $\theta_{j0}$ represents the temperature of the upper copper block 23, and Q represents the calorific value.

[Extent of Falling off of Anisotropic Material]

The extent of falling off of the anisotropic material was evaluated by a test of falling off of the anisotropic material using white paper and the thermally conductive sheet. Specifically, the extent of falling off of the anisotropic material was evaluated by the coloring density of white paper colored due to falling off of the anisotropic material. The test of falling off was performed as follows, and the coloring density of the white paper was measured with a spectrophotometric colorimeter.

(Observation)

After the thermally conductive sheet of 30 mm × 30 mm was put on white wood-free paper and was left with a load of 29.4 N for 30 seconds, the thermally conductive sheet was peeled from the wood-free paper, and the coloring density of the wood-free paper due to the anisotropic material left on the surface of the wood-free paper was estimated as an L* value in the CIE-L*a*b* color system with a spectrophotometric colorimeter ("JX777" manufactured by COLOR

TECHNO SYSTEM CORPORATION).

On that occasion, wood-free paper having an L* value of 98 or more was used as the wood-free paper, and the L*values of 3 arbitrary deep-colored parts and 3 arbitrary light-colored parts in the range where the thermally conductive sheet was placed were measured to adopt the arithmetical mean of them as the L* value of each sample. When the L* takes a larger value, it means that the extent of falling off of the anisotropic material is smaller.

(Evaluation)

    A: L* value is 95 or more.
    B: L* value is 88 to 95.
    C: L* value is less than 88.

Example 1

A mixed composition was obtained by mixing: alkenyl group-containing organopolysiloxane and a hydrogen organopolysiloxane as the polymer matrix (polymer composition); a graphitized carbon fiber (average fiber length of 100 μm, aspect ratio of 10, thermal conductivity of 500 W/m·K) as the anisotropic material; and an aluminum oxide powder (spherical, average particle diameter of 10 μm, aspect ratio of 1.0) as the non-anisotropic material. Each component was blended in such a way that the amount of each component blended was as described on a %-by-volume basis in Table 1 in the heat-conducting layer.

Subsequently, the mixed composition was injected into a die whose thickness was set in such a way as to be sufficiently larger than that of each heat-conducting layer, a magnetic field of 8T was applied in the thickness direction to orient the graphitized carbon fiber in the thickness direction, and the matrix was thereafter cured by heating at 80°C for 60 minutes, thereby obtaining a block-like oriented molding.

Next, the block-like oriented molding was sliced into a sheet-like form having a thickness of 2 mm using a shearing blade, thereby obtaining a heat-conducting layer on which the carbon fiber is exposed. Subsequently, a heat-conducting layer each surface of which was polished was obtained by conducting reciprocation polishing 10 times on each surface of the heat-conducting layer using sandpaper having a grain diameter of abrasive grains of 10 $\mu$m.

A paraffin-based wax (melting point of 46°C, temperature range from the start of melting to the end of melting of 40 to 50°C), aluminum oxide (spherical, average particle diameter of 10 $\mu$m, aspect ratio of 1.0), and isoparaffin as a solvent were mixed to obtain a paste-like composition. The paraffin-based wax and aluminum oxide were blended each in an amount to be as described on a %-by-volume basis in Table 1 when the heat-softening layer was formed. The paste-like composition was applied on each surface of the heat-conducting layer each surface of which was polished, and dried to form a heat-softening layer having an average thickness of 12.5 $\mu$m on each surface of the heat-conducting layer, thereby obtaining a thermally conductive sheet. Results are shown in Table 1.

Example 2

A thermally conductive sheet was obtained in the same manner as in the method of Example 1, except that the paste-like composition was applied on each surface and the whole peripheral end surfaces of the heat-conducting layer and dried to form a heat-softening layer on each surface and the whole peripheral end surfaces of the heat-conducting layer, and the average thickness of the heat-softening layer was changed. Results are shown in Table 1.

Example 3

A thermally conductive sheet was obtained in the same manner as in Example 1, except that the average thickness of the heat-softening layer was changed. Results are shown in Table 1.

Example 4

A thermally conductive sheet was obtained in the same manner as in Example 1, except that the polishing condition of 10 times of reciprocation in Example 1 was change to a polishing condition of 5 times of reciprocation. Results are shown in Table 1.

Example 5

A thermally conductive sheet was obtained in the same manner as in Example 1, except that polishing conducted in Example 1 was not conducted. Results are shown in Table 1

Comparative Example 1

A thermally conductive sheet was obtained in the same manner as in Example 1, except that the heat-softening layer was not formed on each surface of the heat-conducting layer. The thermally conductive sheet of Comparative Example 1 is a thermally conductive sheet composed of only the heat-conducting layer. Results are shown in Table 1.

Examples 6 and 11

Thermally conductive sheets were obtained in the same manner as in Example 1, except that the composition of the heat-softening layer was changed to those as shown in Tables 2 and 3, respectively. Results are shown in Tables 2 and 3.

The polyolefin-based wax shown in Table 2 is a crystalline polyolefin (crystalline poly-alpha-olefin: CPAO), and has a melting point of 42°C and a temperature range from the start of melting to the end of melting of 39 to 45°C. The ester-based wax shown in Table 3 has a melting point of 46°C and a temperature range from the start of melting to the end of melting of 40 to 50°C.

Examples 7 and 12

Thermally conductive sheets were obtained in the same manner as in Example 2, except that the composition of the heat-softening layer was changed to those as shown in Tables 2 and 3, respectively. Results are shown in Tables 2 and 3.

Examples 8 and 13

Thermally conductive sheets were obtained in the same manner as in Example 3, except that the composition of the heat-softening layer was changed to those as shown in Tables 2 and 3, respectively. Results are shown in Tables 2 and 3.

Examples 9 and 14

Thermally conductive sheets were obtained in the same manner as in Example 4, except that the composition of the heat-softening layer was changed to those as shown in Tables 2 and 3, respectively. Results are shown in Tables 2 and 3.

Examples 10 and 15

Thermally conductive sheets were obtained in the same manner as in Example 5, except that the composition of the heat-softening layer was changed to those as shown in Tables 2 and 3, respectively. Results are shown in Tables 2 and 3.

Table 1

| | | Example 1 | Example 2 | Example 3 | Example 4 | Example 5 | Comparative Example 1 |
|---|---|---|---|---|---|---|---|
| Heat-conducting layer (% by volume) | Polymer matrix (silicone rubber) | 37 | 37 | 37 | 37 | 37 | 37 |
| | Anisotropic material (carbon fiber) | 20 | 20 | 20 | 20 | 20 | 20 |
| | Non-anisotropic material (aluminum oxide) | 43 | 43 | 43 | 43 | 43 | 43 |
| Heat-softening layer (% by volume) | Paraffin-based wax | 40 | 40 | 40 | 40 | 40 | - |
| | Aluminum oxide | 60 | 60 | 60 | 60 | 60 | - |
| Details on heat-softening layer | Position | Each surface | Each surface/end surfaces | Each surface | Each surface | Each surface | - |
| | Average thickness ($\mu$m) (* 1) | 12.5 | 17.5 | 25 | 12.5 | 12.5 | - |
| Polishing condition (number of times of reciprocation of sandpaper) at the time of production | | 10 | 10 | 10 | 5 | 0 | 10 |
| Load (psi) on thermally conductive sheet at 40% compression | | 25 | 25 | 40 | 25 | 25 | 25 |
| Thermal resistance value (°C in$^2$/W) of thermally conductive sheet at 10% compression | | 0.081 | 0.083 | 0.2 | 0.096 | 0.112 | 0.08 |

(continued)

| | Example 1 | Example 2 | Example 3 | Example 4 | Example 5 | Comparative Example 1 |
|---|---|---|---|---|---|---|
| Rate (%) of increase in thermal resistance value (°C in$^2$/W) (*2) | 1.25 | 3.75 | 150 | -16.5 | -29.1 | - |
| Extent of falling of anisotropic material | B | A | A | B | A | C |
| L* value | 89.1 | 97 | 98 | 94.5 | 98.2 | 85.8 |

(*1) With respect to the average thickness of the heat-softening layer, when the heat-softening layer is provided on each surface, the average thickness on each surface has an equal value, and this value is described in the table. When the heat-softening layer is provided on each surface and end surfaces, the average thickness on each surface and the average thickness on each end surface have an equal value, and this value is described in the table.

(*2) Rate (%) of increase in thermal resistance value (°C in$^2$/W) = 100 × (thermal resistance value of thermally conductive sheet - thermal resistance value of thermally conductive sheet not having heat-softening layer)/thermal resistance value of thermally conductive sheet not having heat-softening layer

Table 2

| | | Example 6 | Example 7 | Example 8 | Example 9 | Example 10 |
|---|---|---|---|---|---|---|
| Heat-conducting layer(% by volume) | Polymer matrix (silicone rubber) | 37 | 37 | 37 | 37 | 37 |
| | Anisotropic material (carbon fiber) | 20 | 20 | 20 | 20 | 20 |
| | Non-anisotropic material (aluminum oxide) | 43 | 43 | 43 | 43 | 43 |
| Heat-softening layer(% by volume) | Polyolefin-based wax | 40 | 40 | 40 | 40 | 40 |
| | Aluminum oxide | 60 | 60 | 60 | 60 | 60 |
| Details on heat-softening layer | Position | Each surface | Each surface and end surfaces | Each surface | Each surface | Each surface |
| | Average thickness (μm) (*1) | 12.5 | 17.5 | 25 | 12.5 | 12.5 |
| Polishing condition (number of times of reciprocation of sandpaper) at the time of production | | 10 | 10 | 10 | 5 | 0 |
| Load (psi) on thermally conductive sheet at 40% compression | | 25 | 25 | 40 | 25 | 25 |
| Thermal resistance value (°C in$^2$/W) of thermally conductive sheet at 10% compression | | 0.083 | 0.085 | 0.21 | 0.098 | 0.112 |
| Rate (%) of increase in thermal resistance value (°C in$^2$/W) (*2) | | 3.75 | 6.25 | 163 | -14.7 | -29.1 |
| Extent of falling of anisotropic material | | B | A | A | A | A |

(continued)

|  | Example 6 | Example 7 | Example 8 | Example 9 | Example 10 |
|---|---|---|---|---|---|
| L* value | 88.8 | 96.5 | 98.2 | 95.1 | 97.4 |

(*1) With respect to the average thickness of the heat-softening layer, when the heat-softening layer is provided on each surface, the average thickness on each surface has an equal value, and this value is described in the table. When the heat-softening layer is provided on each surface and end surfaces, the average thickness on each surface and the average thickness on each end surface have an equal value, and this value is described in the table.
(*2) Rate (%) of increase in thermal resistance value (°C in$^2$/W) = 100 × (thermal resistance value of thermally conductive sheet - thermal resistance value of thermally conductive sheet not having heat-softening layer)/thermal resistance value of thermally conductive sheet not having heat-softening layer

Table 3

| | | Example 11 | Example 12 | Example 13 | Example 14 | Example 15 |
|---|---|---|---|---|---|---|
| Heat-conducting layer(% by volume) | Polymer matrix (silicone rubber) | 37 | 37 | 37 | 37 | 37 |
| | Anisotropic material (carbon fiber) | 20 | 20 | 20 | 20 | 20 |
| | Non-anisotropic material (aluminum oxide) | 43 | 43 | 43 | 43 | 43 |
| Heat-softening layer(% by volume) | Ester-based wax | 40 | 40 | 40 | 40 | 40 |
| | Aluminum oxide | 60 | 60 | 60 | 60 | 60 |
| Details on heat-softening layer | Position | Each surface | Each surface and end surfaces | Each surface | Each surface | Each surface |
| | Average thickness (μm) (* 1) | 12.5 | 17.5 | 25 | 12.5 | 12.5 |
| Polishing condition (number of times of reciprocation of sandpaper) at the time of production | | 10 | 10 | 10 | 5 | 0 |
| Load (psi) on thermally conductive sheet at 40% compression | | 25 | 25 | 40 | 25 | 25 |
| Thermal resistance value (°C in$^2$/W) of thermally conductive sheet at 10% compression | | 0.082 | 0.084 | 0.2 | 0.098 | 0.113 |
| Rate (%) of increase in thermal resistance value (°C in$^2$/W) (*2) | | 2.5 | 5.0 | 150 | -14.7 | -28.4 |
| Extent of falling of anisotropic material | | B | A | A | B | A |
| L* value | | 89.2 | 96.4 | 98.3 | 94.9 | 97.8 |

(*1) With respect to the average thickness of the heat-softening layer, when the heat-softening layer is provided on each surface, the average thickness on each surface has an equal value, and this value is described in the table. When the heat-softening layer is provided on each surface and end surfaces, the average thickness on each surface and the average thickness on each end surface have an equal value, and this value is described in the table.
(*2) Rate (%) of increase in thermal resistance value (°C in$^2$/W) = 100 × (thermal resistance value of thermally conductive sheet - thermal resistance value of thermally conductive sheet not having heat-softening layer)/thermal resistance value of thermally conductive sheet not having heat-softening layer

As is clear from the results of the above Examples, it was found that the thermally conductive sheet of the present invention can prevent falling off of the anisotropic material by providing the heat-softening layer on the surfaces of the heat-conducting layer. In addition, it was found that the effect of preventing falling off of the anisotropic material is enhanced by providing the heat-softening layer on the surfaces and end surfaces of the heat-conducting layer.

On the other hand, anisotropic material easily fell from the thermally conductive sheet of Comparative Example 1, in which the heat-softening layer is not provided.

In the thermally conductive sheet for which the number of times of polishing is small and the thermally conductive sheet for which a polishing step is not performed, the unevenness of the surface of the heat-conducting layer is considered to be large, but it was found that the effect of reducing the thermal resistance value can be expected by laminating the heat-softening layer.

Reference Signs List

| | |
|---|---|
| 10, 20, 30, 40 | Thermally conductive sheet |
| 12 | Polymer matrix |
| 13, 13X, 13Y | Anisotropic material |
| 14 | Non-anisotropic material |
| 15 | Void |
| 16, 36 | Heat-conducting layer |
| 16A, 16B | Surface of heat-conducting layer |
| 17 | Heat-softening layer |
| 21 | Thermal insulator |
| 22 | Lower copper block |
| 23 | Upper copper block |
| 24 | Heater |
| 25 | Heat sink |
| 26 | Load cell |
| S | Test piece |
| $\theta_{j0}$ | Temperature of upper copper block |
| $\theta_{j1}$ | Temperature of lower copper block |

**Claims**

1.    A thermally conductive sheet (10, 20) comprising:

a heat-conducting layer (16) comprising a polymer matrix (12) and an anisotropic material (13), the anisotropic material (13) oriented in a thickness direction and exposed on a surface (16A, 16B) ; and
a heat-softening layer (17) provided on at least one surface (16A, 16B) of the heat-conducting layer (16), wherein the heat-softening layer (16) covers the anisotropic material (13) exposed on the surface (16A, 16B) of the heat-conducting layer (16) wherein the average fiber length or average major axis length of the anisotropic material is shorter than the thickness of the heat-conducting layer (16).

2.    The thermally conductive sheet (10, 20) according to claim 1, wherein the anisotropic material (13) comprises at least one of a fiber material and a flat material.

3.    The thermally conductive sheet (10, 20) according to claim 1 or 2, wherein the anisotropic material (13) comprises a fiber material, and the fiber material has an average fiber length of 5 to 600 $\mu$m.

4.    The thermally conductive sheet (10, 20) according to claim 2 or 3, wherein the fiber material (13) is a carbon fiber.

5.    The thermally conductive sheet (10, 20) according to claim 1 or 2, wherein the anisotropic material (13) comprises a flat material, wherein the flat material has an average major axis length of 5 to 300 $\mu$m.

6.    The thermally conductive sheet (10, 20) according to claim 2 or 5, wherein the flat material is scale-like graphite.

7.    The thermally conductive sheet (10, 20) according to any one of claims 1 to 6,
wherein the heat-softening layer (17) is provided on each surface of the heat-conducting layer (16).

8. The thermally conductive sheet (10, 20) according to any one of claims 1 to 7,
   wherein the heat-softening layer (17) is also provided on an end surface of the heat conducting layer (16)

9. The thermally conductive sheet (10, 20) according to any one of claims 1 to 8,
   wherein a rate of increase in a thermal resistance value as compared to a thermal resistance value of a thermally conductive sheet not having the heat-softening layer is 10% or less.

10. The thermally conductive sheet (10, 20) according to any one of claims 1 to 9,
    wherein the heat-softening layer (17) comprises a non-silicone-based material.

11. The thermally conductive sheet (10, 20) according to any one of claims 1 to 10,
    wherein the heat-softening layer (17) comprises a wax-like substance having a melting point of 35 to 120°C.

12. The thermally conductive sheet according to claim 11, wherein the wax-like substance is at least one selected from the group consisting of a paraffin-based wax, an ester-based wax, and a polyolefin-based wax.

13. The thermally conductive sheet according to any one of claims 1 to 12, wherein the heat-softening layer (17) comprises a non-anisotropic material.

**Patentansprüche**

1. Wärmeleitende Folie (10, 20), umfassend:

   eine wärmeleitende Schicht (16), umfassend eine Polymermatrix (12) und ein anisotropes Material (13), wobei das anisotrope Material (13) in einer Dickenrichtung ausgerichtet ist und auf einer Oberfläche (16A, 16B) freiliegt; und
   eine wärmeerweichende Schicht (17), die auf mindestens einer Oberfläche (16A, 16B) der wärmeleitenden Schicht (16) vorgesehen ist, wobei
   die wärmeerweichende Schicht (16) das auf der Oberfläche (16A, 16B) der wärmeleitenden Schicht (16) freiliegende anisotrope Material (13) bedeckt,
   wobei die durchschnittliche Faserlänge oder die durchschnittliche Länge der Hauptachse des anisotropen Materials kürzer ist als die Dicke der wärmeleitenden Schicht (16).

2. Wärmeleitende Folie (10, 20) gemäß Anspruch 1, wobei das anisotrope Material (13) mindestens eines von einem Fasermaterial und einem flachen Material umfasst.

3. Wärmeleitende Folie (10, 20) gemäß Anspruch 1 oder 2, wobei das anisotrope Material (13) ein Fasermaterial umfasst und das Fasermaterial eine durchschnittliche Faserlänge von 5 bis 600 $\mu$m aufweist.

4. Wärmeleitfähige Folie (10, 20) gemäß Anspruch 2 oder 3, wobei das Fasermaterial (13) eine Kohlenstofffaser ist.

5. Wärmeleitfähige Folie (10, 20) gemäß Anspruch 1 oder 2, wobei das anisotrope Material (13) ein flaches Material umfasst, wobei das flache Material eine durchschnittliche Länge der Hauptachse von 5 bis 300 $\mu$m aufweist.

6. Wärmeleitende Folie (10, 20) gemäß Anspruch 2 oder 5, wobei das flache Material schuppenartiger Graphit ist.

7. Wärmeleitende Folie (10, 20) gemäß einem der Ansprüche 1 bis 6, wobei die wärmeerweichende Schicht (17) auf jeder Oberfläche der wärmeleitenden Schicht (16) vorgesehen ist.

8. Wärmeleitende Folie (10, 20) gemäß einem der Ansprüche 1 bis 7, wobei die wärmeerweichende Schicht (17) auch auf einer Endfläche der wärmeleitenden Schicht (16) vorgesehen ist.

9. Wärmeleitende Folie (10, 20) gemäß einem der Ansprüche 1 bis 8, wobei die Steigerungsrate des Wärmewiderstandswertes im Vergleich zum Wärmewiderstandswert einer wärmeleitfähigen Folie ohne wärmeerweichende Schicht 10% oder weniger beträgt.

10. Wärmeleitende Folie (10, 20) gemäß einem der Ansprüche 1 bis 9, wobei die wärmeerweichende Schicht (17) ein nichtsilikonbasiertes Material umfasst.

**11.** Wärmeleitende Folie (10, 20) gemäß einem der Ansprüche 1 bis 10, wobei die wärmeerweichende Schicht (17) eine wachsartige Substanz mit einem Schmelzpunkt von 35 bis 120°C umfasst.

**12.** Wärmeleitende Folie gemäß Anspruch 11, wobei die wachsartige Substanz mindestens eine, ausgewählt aus der Gruppe bestehend aus einem Wachs auf Paraffinbasis, einem Wachs auf Esterbasis und einem Wachs auf Polyolefinbasis, ist.

**13.** Wärmeleitende Folie gemäß einem der Ansprüche 1 bis 12, wobei die wärmeerweichende Schicht (17) ein nicht-anisotropes Material umfasst.


**Revendications**

**1.** Feuille thermiquement conductrice (10, 20) comportant :

une couche thermoconductrice (16) comportant une matrice polymère (12) et un matériau anisotrope (13), le matériau anisotrope (13) étant orienté dans une direction d'épaisseur et exposé sur une surface (16A, 16B) ; et
une couche thermoplastifiante (17) disposée sur au moins une surface (16A, 16B) de la couche thermoconductrice (16), dans laquelle
la couche thermoplastifiante (16) recouvre le matériau anisotrope (13) exposé sur la surface (16A, 16B) de la couche thermoconductrice (16),
dans laquelle la longueur de fibre moyenne ou la longueur moyenne dans l'axe principal du matériau anisotrope est plus courte que l'épaisseur de la couche thermoconductrice (16).

**2.** Feuille thermiquement conductrice (10, 20) selon la revendication 1, dans laquelle le matériau anisotrope (13) comporte au moins un élément parmi un matériau fibreux et un matériau plat.

**3.** Feuille thermiquement conductrice (10, 20) selon la revendication 1 ou 2, dans laquelle le matériau anisotrope (13) comporte un matériau fibreux, et le matériau fibreux a une longueur de fibre moyenne de 5 à 600 $\mu$m.

**4.** Feuille thermiquement conductrice (10, 20) selon la revendication 2 ou 3, dans laquelle le matériau fibreux (13) est une fibre de carbone.

**5.** Feuille thermiquement conductrice (10, 20) selon la revendication 1 ou 2, dans laquelle le matériau anisotrope (13) comporte un matériau plat, dans laquelle le matériau plat a une longueur moyenne dans l'axe principal de 5 à 300 $\mu$m.

**6.** Feuille thermiquement conductrice (10, 20) selon la revendication 2 ou 5, dans laquelle le matériau plat est du graphite écailleux.

**7.** Feuille thermiquement conductrice (10, 20) selon l'une quelconque des revendications 1 à 6, dans laquelle la couche thermoplastifiante (17) est disposée sur chaque surface de la couche thermoconductrice (16).

**8.** Feuille thermiquement conductrice (10, 20) selon l'une quelconque des revendications 1 à 7, dans laquelle la couche thermoplastifiante (17) est également disposée sur une surface d'extrémité de la couche thermiquement conductrice (16).

**9.** Feuille thermiquement conductrice (10, 20) selon l'une quelconque des revendications 1 à 8, dans laquelle une vitesse d'augmentation d'une valeur de résistance thermique par rapport à une valeur de résistance thermique d'une feuille thermiquement conductrice n'ayant pas la couche thermoplastifiante est de 10 % ou moins.

**10.** Feuille thermiquement conductrice (10, 20) selon l'une quelconque des revendications 1 à 9, dans laquelle la couche thermoplastifiante (17) comporte un matériau sans silicone.

**11.** Feuille thermiquement conductrice (10, 20) selon l'une quelconque des revendications 1 à 10, dans laquelle la couche thermoplastifiante (17) comporte une substance analogue à une cire ayant un point de fusion de 35 à 120 °C.

**12.** Feuille thermiquement conductrice selon la revendication 11, dans laquelle la substance analogue à une cire est au moins un élément choisi parmi le groupe constitué d'une cire à base de paraffine, d'une cire à base d'ester et d'une cire à base de polyoléfine.

**13.** Feuille thermiquement conductrice selon l'une quelconque des revendications 1 à 12, dans laquelle la couche thermoplastifiante (17) comporte un matériau non anisotrope.

Fig. 1

Fig. 2

## Fig. 3

## Fig. 4

Fig. 5

**EP 3 848 960 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018056315 A
- JP 2018014534 A
- US 2006234056 A1
- US 2011030938 A1
- US 2010172101 A1

26